## Europäisches Patentamt

## European Patent Office

## Office européen des brevets

(19)

(11) Veröffentlichungsnummer: **0 096 332**
**B1**

(12) **EUROPÄISCHE PATENTSCHRIFT**

(45) Veröffentlichungstag der Patentschrift:
24.08.88

(21) Anmeldenummer: 83105343.4

(22) Anmeldetag: 30.05.83

(51) Int. Cl.⁴: **H 03 K 17/95**

(54) Elektronisches, berührungslos arbeitendes Schaltgerät.

(30) Priorität: 09.06.82 DE 3221888

(43) Veröffentlichungstag der Anmeldung:
21.12.83 Patentblatt 83/51

(45) Bekanntmachung des Hinweises auf die Patenterteilung:
24.08.88 Patentblatt 88/34

(84) Benannte Vertragsstaaten:
CH DE FR GB IT LI

(56) Entgegenhaltungen:
EP - A - 0 029 673
DE - A - 2 739 967

IBM TECHNICAL DISCLOSURE BULLETIN, Band 6, Nr. 5,
Oktober 1963, Seiten 24,25, New York, US; E.F.
DONNER: "Position Detector"
IDEM

(73) Patentinhaber: Siemens Aktiengesellschaft Berlin und
München, Wittelsbacherplatz 2, D-8000 München 2 (DE)

(72) Erfinder: Walker, Heinz, Am Kreuzhügl 4,
D-8451 Kümmersbruck (DE)
Erfinder: Riedel, Hans-Dieter, Noetherstrasse 67,
D-8520 Erlangen (DE)

**Beschreibung**

Die Erfindung bezieht sich auf ein elektronisches, berührungslos arbeitendes Schaltgerät, mit einem von aussen durch Gegenstände bedämpfbaren, über einen Oszillator und einen Kondensator fremderregten Schwingkreis und einer die Amplitude der Schwingung erfassenden Auswerteschaltung und einem Verstärkerteil, wobei der einseitig an Masse liegende Schwingkreis über den Kondensator an dem Oszillator angeschaltet ist.

Bei einem bekannten Positionserfassungsgerät der obengenannten Art (IBM Technical Disclosure Bulletin, Band 6, No. 5, Okt. 1963, Seite 24 und 25) wird die Frequenz des Oszillators durch einen zusätzlichen Parallelschwingkreis und einen zusätzlichen Reihenschwingkreis festgehalten. Jede dieser Frequenzen ist auf den Schwingkreis abgestimmt, so dass bei Temperatureinflüssen oder sonstigen Umweltbedingungen die Frequenzen der einzelnen Schwingkreise auseinanderlaufen können.

Der Erfindung liegt daher die Aufgabe zugrunde, ein Gerät der oben bezeichneten Art mit möglichst konstanter Schwingamplitude im ungedämpften Zustand des Schwingkreises zu entwickeln, das im wesentlichen unabhängig von äusseren Einflüssen wie Feuchtigkeit, Temperatur, als auch vom Einfluss der Bauelemente bei hoher Empfindlichkeit, d.h. möglichst hohem Schaltabstand arbeitet. Dies wird auf einfache Weise dadurch erreicht, dass die Frequenz des Oszillators der Resonanzfrequenz des Schwingkreises nachgeregelt wird und dass an der Verbindungsstelle von Kondensator und Schwingkreis die die Amplitude erfassende Auswerteschaltung angeschlossen ist. Vorteilhaft ist es, als Frequenzregler eine aus der Rundfunk- und Fernsehtechnik bekannte PLL phase-locked-loop-Schaltung zu verwenden. Die PLL besteht dabei im wesentlichen aus einem VCO (spannungsgesteuerten Oszillator), dem anzuregenden Schwingkreis einem Phasenmesselement und einem Tiefpass (Der Elektroniker Nr. 6, 1975, Seite EL9–EL15).

Ein weiterer Vorteil des fremderregten Schwingkreises liegt darin, dass die Schwingungen bei Bedämpfung durch Metalle nicht abreissen, sondern nur eine Amplitudenverringerung entsteht. Dadurch reduzieren sich die Eigenzeiten des Schwingkreises auf ein Minimum, so dass die Schaltfrequenz nur um den Faktor der «noise immunity» kleiner als die Oszillatorfrequenz ist.

Zur Aufbereitung des Oszillatorsignals wurde bisher ein Demodulationsverfahren, bei dem zunächst die Wechselspannung gleichgerichtet und geglättet wurde, zur Anwendung gebracht (DE-PS 20 54 100). Dies brachte einen Empfindlichkeitsverlust mit sich, insbesondere auch durch die oben erwähnten Temperatur- und sonstigen Umwelteinflüsse auf die Bauteile. Dadurch, dass dem Schwingkreis ohne Gleichrichtung eine Referenzspannungsvergleichsschaltung mit einem Schmitttriggerausgang nachgeschaltet ist, können diese hier aufgeworfenen Probleme gelöst werden. Es wäre auch denkbar, diese Vergleichsschaltung bei einem nicht frequenzstabilisierten Oszillator anzuwenden. Die Auswertung dieser Impulse ist auf einfache Weise möglich, wenn der Schmitttriggerausgang auf ein retriggerbares Zeitglied aufgeschaltet ist. Eine weitere Ausführungsart mit rein digitaler Arbeitsweise ist realisierbar durch ein 4 bit Schieberegister mit seriellem Eingang sowie parallelen Ausgängen, ausgewertet über eine UND-Verknüpfung. Die Funktion ist dabei dergestalt, dass jeweils z.B. vier Impulse nötig sind, um eine Umschaltung zu veranlassen. Mit einer derartigen Ausführung können gegenüber bekannten Oszillatoren mit Schaltfrequenzen von einigen 100 Hz Schaltfrequenzen von mehreren kHz erreicht werden. Um den Ausgang des erfindungsgemässen Schaltgerätes in bezug auf die Signalart 0 und 1 vorprogrammieren zu können, ist es vorteilhaft, wenn der digitalisierte Ausgang auf den Eingang einer Exklusiv-ODER-Stufe geschaltet ist, dessen anderen Eingang wahlweise an eine Signalspannung anlegbar ist. Die Exklusiv-ODER-Stufe ist als MOS Standard-Baustein bekannt. Hierdurch ist bei dem nunmehr digitalisierten, berührungslos arbeitenden Schaltgerät ein Anschluss an digitale Geräte ohne Schwierigkeiten möglich. Es ist aber denkbar, ein übliches Anpassungsglied mit einem Verstärker dieser Exklusiv-ODER-Stufe nachzuschalten.

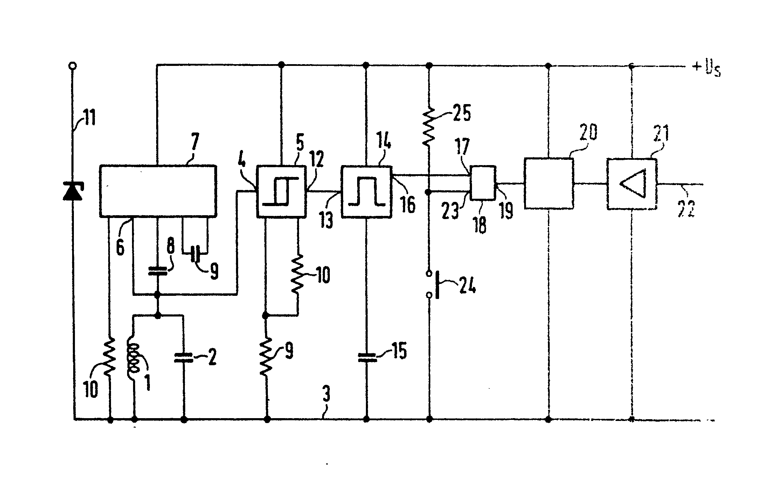

Anhand der Zeichnung wird ein Ausführungsbeispiel gemäss der Erfindung beschrieben.

Der aus der Spule 1 und dem Kondensator 2 bestehende Schwingkreis liegt einseitig an der Minusleitung 3 und andererseits am Eingang 4 der Referenzspannungsvergleichsschaltung 5. Zusätzlich liegt der Schwingkreis am Eingang 6 des Frequenzreglers 7, im vorliegenden Fall der phase-locked-loop-Schaltung, wie er z.B. aus der Druckschrift «Theorie und Anwendung der phase-locked-loop» bekannt ist, und an einen Kondensator 8, der als Phasenmesskondensator mit dem aus der Spule 1 und dem Kondensator 2 bestehenden Schwingkreis zusammenwirkt. Die Referenzspannungsvergleichsschaltung 5 ist mit einem an der Minusleitung 3 einseitig angeschlossenen Widerstand 9 als Referenzspannung zusammengeschaltet. Hierdurch kann die Empfindlichkeit festgelegt werden. Ein weiterer Widerstand 10 ist als Hysteresewiderstand benutzt worden. Die Referenzspannung kann auch von aussen her über die Leitung 11 beeinflusst werden. Der Ausgang 12 der aus der Druckschrift bekannten Referenzspannungsvergleichsschaltung 5, die, wie aus dieser Druckschrift zu ersehen ist, mit einem Schmitttriggerausgang versehen ist, liegt beispielsweise am Eingang 13 eines retriggerbaren Zeitgliedes 14. Dieses Zeitglied ist über einen die Zeitimpulse bestimmenden Kondensator 15 an die Minusleitung angeschlossen. Der Ausgang 16 des retriggerbaren Zeitgliedes 14 ist mit einem Eingang 17 einer Exklusiv-ODER-Stufe 18 zusammengeschaltet, dessen Ausgang 19 über ein Anpassungsglied 20 und einen Verstärker 21 das Ausgangssignal 22 abgibt. Denkbar ist aber auch ein Schieberegister mit seriellem input und parallel verknüpftem output, um eine «Störungsunterdrückung» zu erreichen. Ob das Ausgangssignal 22 positiv oder negativ ist, hängt von der Beschaltung des zweiten Einganges 23 der Exklusiv-ODER-Stufe 18 ab. Im bezeichneten Fall liegt kein Signal auf dem Eingang 23. Nach Schliessen des Programmierschalters 24 sorgt der Widerstand 25 für ein Signal am Eingang 23. Die Exklusiv-ODER-Stufe 18 gibt am Ausgang 19 lediglich ein Signal ab, wenn entweder am Eingang 17 oder am Eingang 23 ein Signal ansteht, d.h. bei geschlossenem Programmierschalter 24 ist bei nicht bedämpftem Schwingkreis ein Ausgangssignal 22 vorhanden, und bei geöffnetem Schalter 24 erscheint bei Bedämpfung ein Signal 22.

Die Funktion des erfindungsgemässen Schaltgerätes wird wie folgt beschrieben. Solange der Schwingkreis durch äussere Gegenstände unbedämpft schwingt, wird jeder Impuls in der Referenzspannungsvergleichsschaltung mit der Referenzspannung verglichen. Sofern die Impulse, d.h. im unbedämpften Zustand, eine entsprechende Höhe erreichen, werden diese Impulse weitergegeben. Das retriggerbare Zeitglied 14 erhält in jeder Halbwelle einen entsprechenden Impuls. Ebenso werden die Impulse auch einem Schieberegister zugeführt. Die Laufzeit des retriggerbaren Zeitgliedes ist grösser als die Periodendauer der Oszillatorschwingung und somit ergibt sich ein Dauersignal am Ausgang 16. Dieses Ausgangssignal wird, wie vorn erwähnt, über die Exklusiv-ODER-Stufe, das Anpassungsglied 20 und den Verstärker 21 weiterverarbeitet. Um Fehlimpulse zu vermeiden, spricht das retriggerbare Zeitglied 14 erst nach einer mehrfachen Impulsfolge, beispielsweise nach drei Impulsen an.

Es ist auch möglich, dass das Ausgangssignal 22 einen an der Spannungsversorgung liegenden Thyristor oder Triac zur Betätigung der in Reihe liegenden Last schaltet, so dass das erfindungsgemässe Schaltgerät auch als Zweidrahtschaltgerät Verwendung finden kann. Die wesentlichen Bauelemente des erfindungsgemässen Schaltgerätes können ohne Schwierigkeit in einem Integrated Circuit (IC) zusammengefasst werden, so dass auch vom Aufbau her eine räumlich kleine und einfache Aufbauform möglich ist.

### Patentansprüche

1. Elektronisches, berührungslos arbeitendes Schaltgerät, mit einem von aussen durch Gegenstände bedämpfbaren, über einen Oszillator und einen Kondensator (8) fremderregten Schwingkreis (1, 2) und einer die Amplitude der Schwingung erfassenden Auswerteschaltung (5) und einem Verstärkerteil (21), wobei der einseitig an Masse (3) liegende Schwingkreis (1, 2) über den Kondensator (8) an dem Oszillator (7) angeschaltet ist, dadurch gekennzeichnet, dass die Frequenz des Oszillators der Resonanzfrequenz des Schwingkreises (1, 2) nachgeregelt wird und dass an der Verbindungsstelle von Kondensator (8) und Schwingkreis (1, 2) die die Amplitude erfassende Auswerteschaltung (5) angeschlossen ist.

2. Gerät nach Anspruch 1, dadurch gekennzeichnet, dass der Frequenzregler (7) in einem Phase-locked Loop (PLL) vorhanden ist.

3. Gerät nach Anspruch 1 oder 2, dadurch gekennzeichnet, dass dem Schwingkreis (1, 2) ohne Gleichrichtung eine Referenzspannungsvergleichsschaltung (5) mit einem Schmitt-Trigger-Ausgang nachgeschaltet ist.

4. Gerät nach Anspruch 3, dadurch gekennzeichnet, dass der Schmitt-Trigger-Ausgang auf ein retriggerbares Zeitglied (14) aufgeschaltet ist.

5. Gerät nach Anspruch 3, dadurch gekennzeichnet, dass der Schmitt-Trigger auf ein Schieberegister (14) geschaltet wird.

6. Gerät nach einem der vorhergehenden Ansprüche, dadurch gekennzeichnet, dass der digitalisierte Ausgang (16) auf den einen Eingang (17) einer Exklusiv-ODER-Stufe (18) geschaltet ist, dessen anderer Eingang (17) wahlweise an eine Signalspannung (24, 25) anlegbar ist.

### Claims

1. Electronic switching device which operates in a contactless manner, having an oscillating circuit (1, 2) which can be damped from the outside by means and which is separately excited by way of an oscillator and a capacitor (8), an evaluation circuit (5) which detects the amplitude of the oscillation, and an amplifier part (21), with the oscillating circuit (1, 2), which is connected one-sidedly to earth (3), being connected by way of the capacitor (8) to the oscillator (7), characterised in that the frequency of the oscillator is re-adjusted to the resonant frequency of the oscillating circuit (1, 2) and in that the evaluation circuit (5), which detects the amplitude, is linked to the junction point of capacitor (8) and oscillating circuit (1, 2).

2. Device according to claim 1, characterised in that the frequency regulator (7) is in a phase-locked loop (PLL).

3. Device according to claim 1 or 2, characterised in that a reference voltage comparator circuit (5) with a Schmitt-trigger-output is connected downstream of the oscillating circuit (1, 2) without rectification.

4. Device according to claim 3, characterised in that the Schmitt-trigger-output is connected to a timing element (14) which is capable of being retriggered.

5. Device according to claim 3, characterised in that the Schmitt-trigger is connected to a shift register (14).

6. Device according to one of the preceding claims, characterised in that the digitized output (16) is connected to the one input (17) of an exclusive-OR-stage (18), the other input (23) of which can be applied selectively to a signal voltage (24, 25).

### Revendications

1. Appareil de commutation électronique, fonctionnant sans contact et comportant un circuit oscillant (1, 2), qui peut être amorti de l'extérieur par des objets et auquel peut être appliquée une excitation étrangère par l'intermédiaire d'un oscillateur et d'un condensateur (8), un circuit d'évaluation (5) détectant l'amplitude de l'oscillation et une partie formant amplificateur (21), et dans lequel le circuit oscillant (1, 2), qui d'un côté est raccordé à la masse (3), est raccordé par l'intermédiaire du condensateur (8) à l'oscillateur (7), caractérisé par le fait que la fréquence de l'oscillateur est asservie par réglage à la fréquence de résonance du circuit oscillant (1, 2) et que le circuit d'évaluation (5) qui détecte l'amplitude, est raccordé au point de jonction entre le condensateur (8) et le circuit oscillant (1, 2).

2. Appareil suivant la revendication 1, caractérisé par le fait que le régulateur de fréquence (7) est situé dans une boucle à verrouillage de phase (PLL).

3. Appareil suivant la revendication 1 ou 2, caractérisé par le fait qu'un circuit (5) de comparaison de la tension de référence, comportant une sortie reliée à un déclencheur de Schmitt, est branché en aval du circuit oscillant (1, 2), sans aucun redressement.

4. Appareil suivant la revendication 3, caractérisé par le fait que la sortie du déclencheur de Schmitt est envoyée à un circuit de temporisation redéclenchable (14).

5. Appareil suivant la revendication 3, caractérisé par le fait que le déclencheur de Schmitt est raccordé à un registre à décalage (14).

6. Appareil suivant l'une des revendications précédentes, caractérisé par le fait que la sortie numérisée (16) est raccordée à une entrée (17) d'un circuit OU-Exclusif (18), à l'autre entrée (17) duquel peut être appliquée au choix une tension de signal (24, 25).